# EUROPEAN PATENT SPECIFICATION

(11) **EP 3 211 435 B1**
(45) Date of publication and mention of the grant of the patent: **04.09.2024**
(21) Application number: 16157499.1
(22) Date of filing: 26.02.2016
(51) Int. Cl.: G01R 15/04, G01R 15/06, G01R 15/16

(54) **VOLTAGE MEASURING DEVICE FOR THE USE IN MEDIUM OR HIGH VOLTAGE APPLICATION**
SPANNUNGSMESSUNGSVORRICHTUNG ZUR VERWENDUNG IN MITTEL- ODER HOCHSPANNUNGSANWENDUNG
DISPOSITIF DE MESURE DE TENSION POUR L'UTILISATION DANS DES APPLICATIONS DE HAUTE OU MOYENNE TENSION

(43) Date of publication of application: 30.08.2017
(73) Proprietor: ABB Schweiz AG, 5400 Baden (CH)
(72) Inventor: Podzemny, Jaromir, 621 00 Brno (CZ); Pavlas, Marek, 683 54 Otnice (CZ); Javora, Radek, 664 62 Hrusovany u Brna (CZ)
(74) Representative: Maiwald GmbH

(56) References cited:
- EP-A1- 2 693 223
- DE-A1- 3 025 818
- DE-A1- 3 709 943
- US-A- 3 835 353

## Description

The invention relates to a voltage measurement device with a conductive or semi-conductive surface, for the use in medium or high voltage equipment or switchgear, and to a medium voltage equipment or switchgear comprising such a voltage measurement device.

To prevent electrical shock hazard through surface of the device in gas insulated switchgear (GIS) applications working at medium voltage levels, the surface of conventional voltage transformers used for voltage measurement or protection purposes is usually coated by the conductive or semi-conductive layer, which is grounded. Some designs of voltage transformers are also using additional metal plates or conductive surfaces, within which the voltage transformer body is cast, thus creating the conductive surface. This is well known, for example from the US 2006/0202671 A1 .

In case of voltage sensors intended for GIS applications, those devices have to fulfil the same prevention from electrical shock as conventional voltage transformers. One can use the semiconductive or conductive surface treatment as in case of conventional voltage transformers or also the additional metal plating/box.

The technology of conductive or semiconductive surface deposition requires some investments into necessary production devices/tools to be able to apply conductive particles in a reliable way.

The technology of additional metal box is easier and cheaper from production tools point of view, but results in further problems, related to product design. Delamination of the semiconductive or conductive box/layer from the internal insulation material can increase the risk of partial discharges and thus decrease life time of the device.

DE3025818A1 describes that a joint housing comprises an insulated body of silicon rubber or Ethylene Propylene Copolymer materials in which there is a screen electrode at high voltage potential and a reference or control electrode at earth potential all contained in a metallic housing. It is described that the metallic housing is embedded in the insulating body. It is describe that a test electrode is located inside the metallic housing and reaches into the proximity of the screen electrode, the test electrode is an insulator with a conducting coating, and that the test electrode makes an external appearance through a boring in the metallic housing and has a wrap around grommet lip to prevent contact with the metal housing.

DE3709943A1 describes that in a cable termination comprising an insulator which is provided with a conducting outer layer and has a capacitive voltage-measuring device with a measuring electrode which is located in the wall of the insulator and can be electrically connected by an electrical connecting piece to the conducting outer layer of the insulator, it is provided that the measuring electrode has a nut with a blind hole, that there is provided a screw which is located in a bore of the wall of the insulator, can be screwed into the internal thread of the nut of the measuring electrode and, in the correspondingly screwed-in state, establishes an electrically conducting connection between the conducting outer layer of the insulator and the measuring electrode, and that the bore for receiving the screw is provided in the region of the conducting outer layer with an insulated lead-through.

EP2693223A1 relates to a voltage measurement device with an insulating body, for the use in medium or high voltage equipment or switchgears, with an impedance divider consisting of at least one high voltage impedance and at least one low voltage impedance in series, and with shielding electrodes. It is described that in order to do optimized voltage measurement design for a given application, preventing risk of malfunctionality in case the same device it is used in other application or at severe environmental or operating conditions, at least one high voltage shielding electrode and/or at least one low voltage shielding electrode which dimensions are applied to the physical length of the impedances, and that the shielding electrodes surround the high and/or low voltage impedances providing required voltage division ratio, and which are located either inside or outside of the insulating body in order to distribute the electric field in the best way to reduce electric field stress either inside or outside of the said device, and that the output of the impedance divider is connected to a shielded cable, which is also part of this device.

US3835353A describes that in a capacitive voltage-dividing device of the type having a high-voltage capacitor connected in series with a low-voltage capacitor for high voltage measurements, particularly in connection with fully insulated, metal clad, high voltage switchgear, an improved arrangement comprises an inner electrode connected to the high voltage bus of the switchgear and extending through an opening in the metal cover; an intermediate or measuring electrode surrounding the inner electrode; and an outer electrode forming a cap-like extension of the metal cover and surrounding the measuring electrode in spaced, insulated relation. It is described that the measuring electrode in combination with the inner electrode forms the high voltage capacitor, and the measuring electrode in combination with the outer electrode forms the low voltage capacitor of the arrangement.

Starting from that, the object of the invention is, to avoid effect of delamination of insulation material from the semiconductive or conductive box/layer and thus to avoid increased partial discharge behaviour of the device.

In order to solve this problem, the invention is embellished in independent claim 1. Claim 1 defines a voltage measuring device for medium or high voltage use. Dependent claim 6 defines a medium voltage equipment or switchgear. The invention and its scope of protection is defined by the claims.

Several embodiments of the invention are given in the dependent claims.

Considering this object, the invention is, that the voltage measuring device contains an internal electrode, which is cast into the insulation material under an outer conductive or semiconductive layer, and that the internal electrode is electrically connected with the outer conductive or semi-conductive layer or housing.

At least one end of internal electrode is shaped into a radius which is preferably bigger or equal to 1 mm.

The internal electrode including the radius is manufactured of conductive or semiconductive material.

For the radius at the internal electrode, two alternative embodiments are possible.

First advantageous alternative is, that the internal electrode, including the radius is manufactured as at least two pieces of conductive or semiconductive material, all being electrically connected.

Second advantageous alternative is, that the outer radius of internal electrode is formed from solid material, metal sheet or as a wire wound in the solenoid shape. In that case the internal electrode, including the radius is manufactured as a one-piece part, of conductive or semiconductive material.

The voltage measuring device contains also an additional high voltage electrode for electric field distribution.

Furthermore, the voltage measuring device contains also an additional low voltage electrode for electric field distribution.

Several advantageous applications with such voltage measuring devices are, that voltage measuring device is preferably used in an assembly with medium or high voltage cable ends, or that voltage measuring device is preferably used in an assembly with medium or high voltage cable terminations.

Furthermore, the voltage measuring device is preferably used in an assembly with medium or high voltage busbar adapters.

Finally, the voltage measuring device is preferably used in an assembly with medium or high voltage gas insulated switchgears.

Based on that, the proposed invention uses cast electrode in the insulation material. This electrode is electrically connected with an outer conductive or semi-conductive layer or a box. The said electrode does not prevent the delamination of the outer conductive or semi-conductive layer but its presence eliminates partial discharges by changing electrical potentials within said device. Moreover the electrode is shaped into a radius providing better electric field distribution inside of the device, as well as in service/applications, improving electric field when assembled together with other electrical equipment like cable ends, cable terminations or busbar adapters.

An embodiment of the invention is shown in the drawings.
Figure 1: : Voltage measuring device having radius and internal electrode made of two electrically connected pieces.
Figure 2: : Voltage measuring device having radius and internal electrode made of single piece/material.

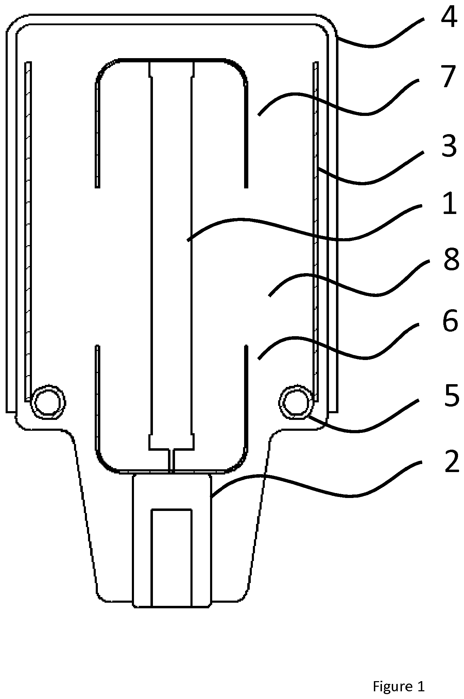

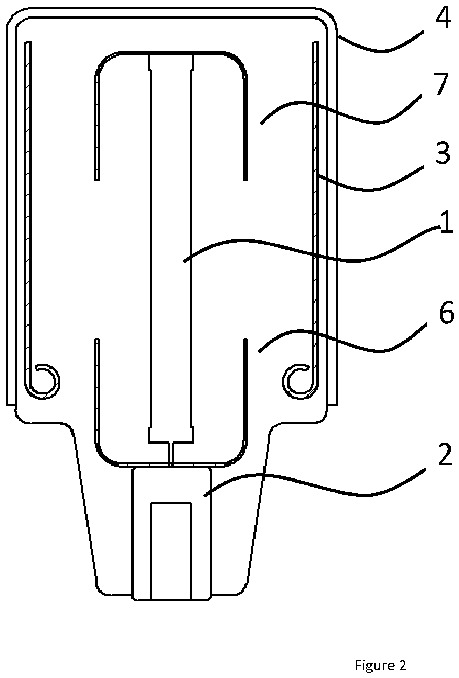

Figure 1, as well as figure 2 are showing, that the voltage measuring device contains an internal electrode 3, which is casted into the insulation material 8, and in which is also casted the voltage divider. The internal electrode is electrically connected with the outer conductive or semiconductive layer 4. The internal electrode 3 prevents the increase of partial discharges, which could arise due to delamination of the conductive or semi-conductive layer 4 from the insulation material 8. The end of the internal electrode 3 is shaped into radius 5, to provide more homogenous electric field distribution.

The resistive voltage divider 1 is provided with a high voltage divider electrode 6, and a low voltage divider electrode 7. The electrodes 6 and 7 are embellished in a cuplike shape.

So as a result, the voltage divider is working as resistive voltage divider or as a capacitive voltage divider, or as a combination of both.

So the internal electrode 3 is dimensioned and positioned as such, that it extends nearly over the complete length of the voltage divider 1.

The end side of the internal electrode 3 near or at the low voltage side 7 of the voltage divider 1, is without any additional shape, whereas the end near or at the high voltage side 6, is shaped with a rounded structure of the internal electrode 3.

So the difference of the shown embodiments in figure 1 and figure 2 is, that rounded structure 5 of the internal electrode 3 at the high voltage side 6 of the voltage divider 1 are realized in different ways.

In figure 1, the rounded structure 5 is a separate structure, but electrically connected to the internal electrode.

In figure 2, the rounded structure 5 is an integral structure of the internal electrode 3.

### Numbering:

1 : resistive voltage divider or capacitive voltage divider or their combination
2 : primary terminal for medium voltage connection
3 : internal electrode cast in insulation material 8, electrically connected with outer conductive / semi-conductive layer 4. The electrode is shaped into a radius 5 at the end to improve electric field distribution
4 : conductive or semi-conductive layer
5 : radius of the internal electrode 3
6 : high voltage divider electrode
7 : low voltage divider electrode
8 : insulation material

## Claims

1. A voltage measuring device for medium or high voltage use, comprising:
- a resistive and/or capacitive voltage divider (1);
- an electrode (3); and
- a terminal (2) for medium voltage connection;
wherein, the voltage divider (1) comprises at a first end a cuplike shaped high voltage divider electrode (6) and at a second end a cuplike shaped low voltage divider electrode (7);
wherein, the first end of the voltage divider (1) is connected to the terminal (2);
wherein, the electrode (3) is manufactured of conductive or semi-conductive material;
wherein the electrode (3) surrounds and extends over substantially the entire length of the voltage divider (1) between the first end and the second end of the voltage divider (1);
wherein, an end of the electrode (3) near to the first end of the voltage divider (1) is shaped into a radius (5);
wherein, the voltage divider (1) and the electrode (3) are cast into an insulation material (8) such that the insulation material (8) surrounds the voltage divider (1) and the electrode (3);
wherein an outer conductive or semi-conductive layer (4) is laminated to the insulation material (8), and
wherein the outer conductive or semi-conductive layer (4) is electrically connected to the electrode (3).

2. Voltage measuring device according to claim 1,
wherein the radius (5) at the end of electrode (3) is bigger or equal to 1 mm.

3. Voltage measuring device according to any of claims 1-2,
wherein the electrode (3) is manufactured as a one-piece part.

4. Voltage measuring device according to any of claims 1-2,
wherein the electrode (3) is manufactured as at least two pieces, all being electrically connected.

5. Voltage measuring device according to any of the aforementioned claims,
wherein the radius (5) at the end of the electrode (3) is formed from solid material, metal sheet or from a wire wound in a solenoid shape.

6. A medium voltage equipment or switchgear comprising a voltage measuring device according to any of claims 1-5.

## Patentansprüche

1. Spannungsmessgerät für Mittel- oder Hochspannungsanwendungen, umfassend:
- einen resistiven und/oder kapazitiven Spannungsteiler (1);
- eine Elektrode (3); und
- einen Anschluss (2) für Mittelspannung;
wobei der Spannungsteiler (1) an einem ersten Ende eine becherförmige Hochspannungsteiler-Elektrode (6) und an einem zweiten Ende eine becherförmige Niederspannungsteiler-Elektrode (7) umfasst;
wobei das erste Ende des Spannungsteilers (1) mit dem Anschluss (2) verbunden ist; wobei die Elektrode (3) aus leitfähigem oder halbleitendem Material hergestellt ist;
wobei die Elektrode (3) den Spannungsteiler (1) im Wesentlichen über die gesamte Länge zwischen dem ersten Ende und dem zweiten Ende des Spannungsteilers (1) umgibt und sich darüber erstreckt;
wobei ein Ende der Elektrode (3) in der Nähe des ersten Endes des Spannungsteilers (1) in einen Radius (5) geformt ist;
wobei der Spannungsteiler (1) und die Elektrode (3) in ein Isolationsmaterial (8) eingegossen sind, sodass das Isolationsmaterial (8) den Spannungsteiler (1) und die Elektrode (3) umgibt;
wobei eine äußere leitfähige oder halbleitende Schicht (4) auf das Isolationsmaterial (8) laminiert ist; und
wobei die äußere leitfähige oder halbleitende Schicht (4) elektrisch mit der Elektrode (3) verbunden ist.

2. Spannungsmessvorrichtung nach Anspruch 1, wobei der Radius (5) am Ende der Elektrode (3) größer oder gleich 1 mm ist.

3. Spannungsmessvorrichtung nach einem der Ansprüche 1-2, wobei die Elektrode (3) als ein einteiliges Bauteil hergestellt ist.

4. Spannungsmessvorrichtung nach einem der Ansprüche 1-2, wobei die Elektrode (3) aus zumindest zwei Teilen hergestellt ist, die alle elektrisch verbunden sind.

5. Spannungsmessvorrichtung nach einem der vorhergehenden Ansprüche, wobei der Radius (5) am Ende der Elektrode (3) aus festem Material, Metallblech oder aus einem in einer Spulenform gewickelten Draht geformt ist.

6. Mittelspannungsanlage oder Schaltanlage, umfassend eine Spannungsmessvorrichtung nach einem der Ansprüche 1-5.

## Revendications

1. Dispositif de mesure de tension pour une utilisation à moyenne ou haute tension, comprenant :
- un diviseur de tension résistif et/ou capacitif (1) ;
- une électrode (3) ; et
- une borne (2) pour la connexion à la moyenne tension ;
le diviseur de tension (1) comprenant, au niveau d'une première extrémité, une électrode à basse tension de diviseur (6) en forme de coupelle et, au niveau d'une seconde extrémité, une électrode à basse tension de diviseur (7) en forme de coupelle ;
la première extrémité du diviseur de tension (1) étant connectée à la borne (2) ;
l'électrode (3) étant fabriquée en matériau conducteur ou semi-conducteur ;
l'électrode (3) entourant sensiblement toute la longueur du diviseur de tension (1) et s'étendant sur celle-ci, entre la première extrémité et la seconde extrémité du diviseur de tension (1) ;
une extrémité de l'électrode (3) à proximité de la première extrémité du diviseur de tension (1) se présentant sous la forme d'un rayon (5) ;
le diviseur de tension (1) et l'électrode (3) étant coulés dans un matériau d'isolation (8) de telle sorte que le matériau d'isolation (8) entoure le diviseur de tension (1) et l'électrode (3) ;
une couche extérieure conductrice ou semi-conductrice (4) étant stratifiée sur le matériau d'isolation (8) ; et
la couche extérieure conductrice ou semi-conductrice (4) étant connectée électriquement à l'électrode (3).

2. Dispositif de mesure de tension selon la revendication 1,
dans lequel le rayon (5) au niveau de l'extrémité de l'électrode (3) est supérieur ou égal à 1 mm.

3. Dispositif de mesure de tension selon l'une quelconque des revendications 1 et 2,
dans lequel l'électrode (3) est fabriquée en une seule pièce.

4. Dispositif de mesure de tension selon l'une quelconque des revendications 1 et 2,
dans lequel l'électrode (3) est fabriquée en au moins deux pièces, toutes connectées électriquement.

5. Dispositif de mesure de tension selon l'une quelconque des revendications précédentes,
dans lequel le rayon (5) au niveau de l'extrémité de l'électrode (3) est constitué d'un matériau solide, d'une feuille de métal ou d'un fil enroulé en forme de solénoïde.

6. Équipement ou appareillage de commutation à moyenne tension comprenant un dispositif de mesure de tension selon l'une quelconque des revendications 1 à 5.
